# EUROPEAN PATENT APPLICATION

(11) **EP 1 909 053 A2**
(43) Date of publication of application: **09.04.2008**
(21) Application number: 07251910.1
(22) Date of filing: 09.05.2007
(51) Int. Cl.: F28D 1/02, F28D 15/00, H01L 23/473, H05K 7/20

(54) **Heat dissipating system and method**

(30) Priority: 29.09.2006 CN 200610142190
(71) Applicant: Orra Corporation, Santa Clara, San Diego, CA 95054 (US)
(72) Inventor: Luo, Chin-Kuang, Taichung City (TW)
(74) Representative: Albutt, Anthony John

(57) **Abstract**

A heat dissipating system includes: a heat-absorbing unit (5) having at least one cavity body (51, 52, 53, 54) adapted to contact a heat source (35, 7), and a working fluid (30) received in the cavity body (51, 52, 53, 54); a condenser (4) to condense the working fluid (30) ; and a tubing unit (6) connected fluidly to the condenser (4) and the heat-absorbing unit (5) . The working fluid (30) flows through the tubing unit (6) to circulate from the condenser (4) to the heat-absorbing unit (5) by gravity and from the heat-absorbing unit (5) to the condenser (4) by natural convection. The tubing unit (6) forms a closed circulating loop with the heat-absorbing unit (5) and the condenser (4).

## Description

The invention relates to heat dissipation, more particularly to a heat dissipating system and method.

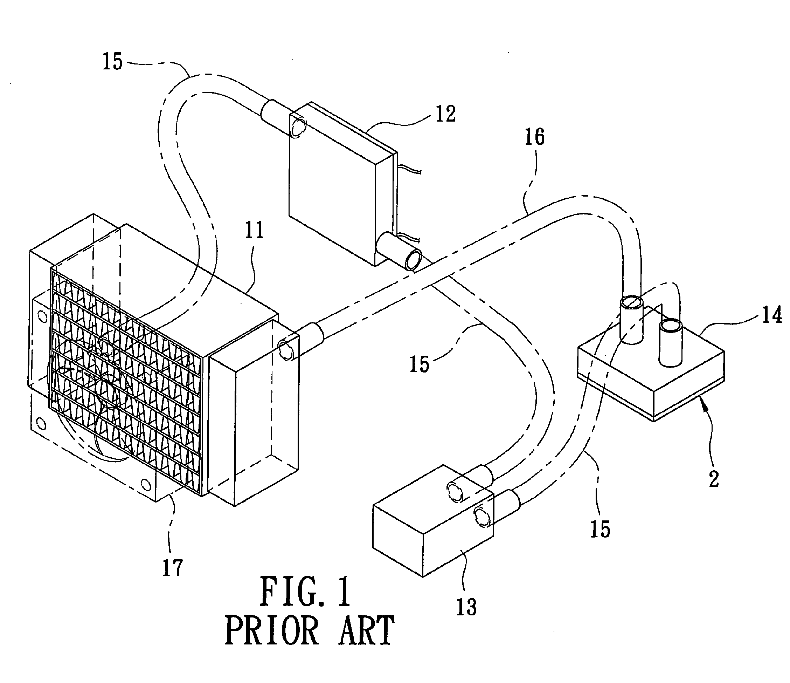

Referring to Figure 1, a liquid-cooling heat dissipating system, as disclosed in Taiwanese Publication No. M295424, includes a heat sink 11 for exchanging heat with external cold air by convection, a thermoelectric cooler 12, a pressure-increasing pump 13 to circulate a working fluid within the system, a liquid-cooling connector 14 in contact with a heat source 2, three input pipes 15 for interconnecting the heat sink 11, the thermoelectric cooler 12, the pump 13, and the liquid-cooling connector 14 in series, an output pipe 16 connected fluidly to the heat sink 11 and the liquid-cooling connector 14, and a fan 17 for directing a current of cold air toward the heat sink 11. The heat source 2 may be a central processing unit of a computer.

When the pressure-increasing pump 13 is activated, the working fluid in the liquid-cooling connector 14 circulates toward the heat sink 11 after absorbing the heat generated by the heat source 2. The heat sink 11 then exchanges heat with the external current of cold air so as to dissipate the heat. Although the aforementioned heat dissipating system can achieve its intended purpose, in actual practice, it has the following drawbacks:
1. Since the aforementioned liquid-cooling heat dissipating system relies on the pressure-increasing pump 13 to circulate the working fluid, the system not only has more components, is more costly, and is more noisy, but also generates more heat itself due to the pressure-increasing pump 13. This runs counter to efforts at reducing the temperature of the working fluid in the system and, therefore, reduces the cooling efficiency of the system.
2. If the aforementioned working fluid is water, the water will freeze when the system is used in a cold area with a temperature lower than 0°C, thereby rendering the system useless. Further, if there is water leakage in the system, circuitry in the heat source 2 and/or elements of the system itself may be destroyed.

Therefore, the object of the present invention is to provide a heat dissipating system that can reduce noise to a minimum and that can effectively enhance heat dissipation. The present invention also provides a method for dissipating heat from a heat source.

According to one aspect of this invention, a heat dissipating system comprises: a heat-absorbing unit having at least one cavity body adapted to contact a heat source, and a working fluid received in the cavity body; a condenser to condense the working fluid; and a tubing unit connected fluidly to the condenser and the heat-absorbing unit. The working fluid flows through the tubing unit to circulate from the condenser to the heat-absorbing unit by gravity and from the heat-absorbing unit to the condenser by natural convection. The tubing unit forms a closed circulating loop with the heat-absorbing unit and the condenser.

According to another aspect of this invention, a computer module comprises a housing, at least one chip disposed in the housing, a heat-absorbing unit, a condenser, and a tubing unit. The heat-absorbing unit has at least one cavity body contacting the chip, and a working fluid received in the cavity body. The condenser is disposed in the housing to condense the working fluid. The tubing unit is connected fluidly to the condenser and the heat-absorbing unit. The working fluid flows through the tubing unit to circulate from the condenser to the heat-absorbing unit by gravity and from the heat-absorbing unit to the condenser by natural convection. The tubing unit forms a closed circulating loop with the heat-absorbing unit and the condenser.

According to still another aspect of this invention, a method for dissipating heat from a heat source comprises the steps of: (a) contacting the heat source with a heat-absorbing cavity body to cause a working fluid contained in the cavity body to vaporize; (b) allowing the vaporized working fluid to flow upward and enter a condenser by natural convection; (c) condensing the vaporized working fluid in the condenser; (d) cooling the condensed working fluid using a thermoelectric cooler and a heat sink; and (e) allowing the condensed working fluid to flow downward and back into the cavity body by gravity.

Other features and advantages of the present invention will become apparent in the following detailed description of the preferred embodiments with reference to the accompanying drawings, of which:
Figure 1 is a perspective view of a conventional liquid-cooling heat dissipating system disclosed in Taiwanese Publication No. M295424;
Figure 2 is a perspective view of the first preferred embodiment of a heat dissipating system and method according to the present invention;
Figure 3 is a fragmentary sectional view of a condenser of the first preferred embodiment;
Figure 4 illustrates the first preferred embodiment installed in a computer module;
Figure 5 is a schematic side view of Figure 4;
Figure 6 is a flow chart illustrating the steps involved during operation of the heat dissipating system of the present invention;
Figure 7 is a schematic view of the second preferred embodiment of a heat dissipating system and method according to the present invention; and
Figure 8 is a schematic view of the third preferred embodiment of a heat dissipating system and method according to the present invention.

Before the present invention is described in greater detail, it should be noted that the same reference numerals have been used to denote like elements throughout the specification.

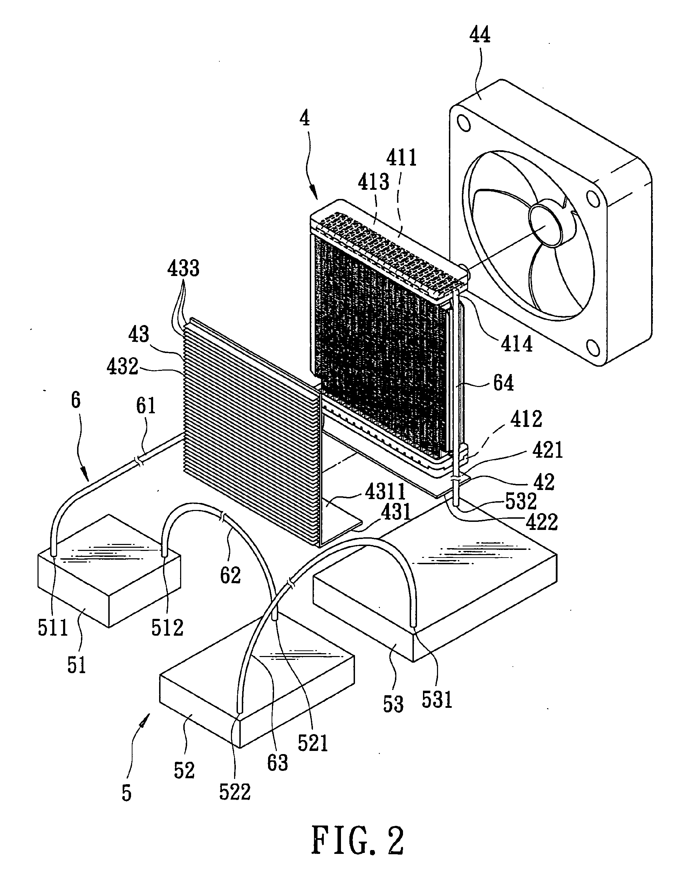

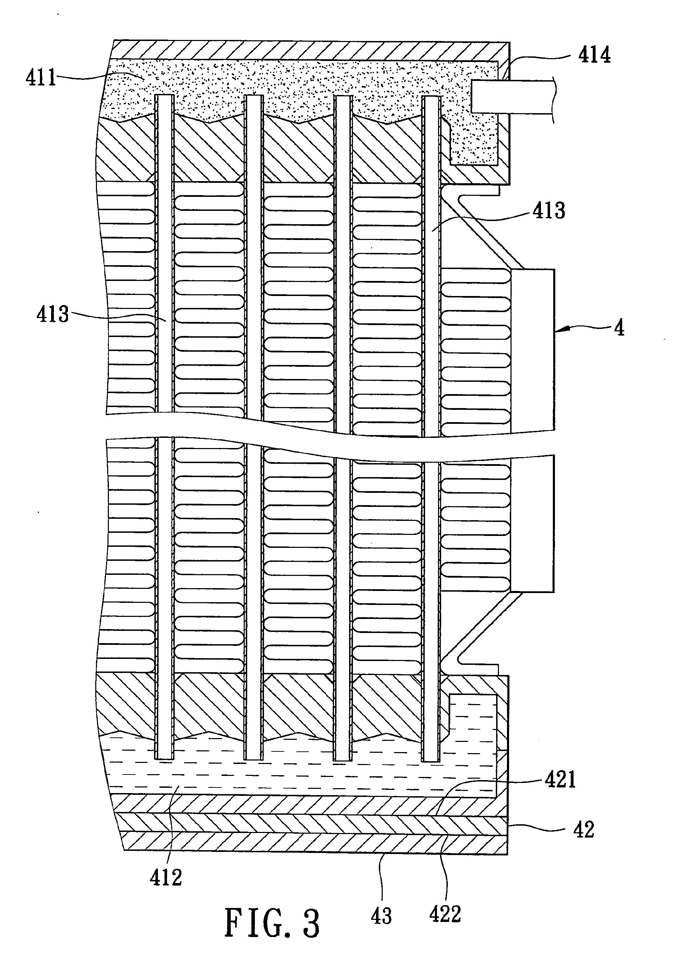

Referring to Figures 2 to 5, the first preferred embodiment of a heat dissipating system according to the present invention is installed in a computer module 3. The computer module 3 has a housing 33 defining upper and lower chambers 31, 32, a mounting board 34 fixed inside the lower chamber 32, and a plurality of module chips 35 mounted on the mounting board 34. The heat dissipating system of the present invention comprises a condenser 4, a heat-absorbing unit 5, and a tubing unit 6. The module chips 35 are heat sources to undergo heat dissipation by the system of the present invention.

The condenser 4 is disposed in the upper chamber 31 of the computer module 3, and includes a vapor-receiving part 411 formed on a top end thereof, an inlet 414 connected fluidly to the vapor-receiving part 411, a liquid-receiving part 412 formed on a bottom end thereof, an outlet 415 connected fluidly to the liquid-receiving part 412, a plurality of channels 413 connected between the vapor-receiving and liquid-receiving parts 411, 412, and a thermoelectric cooler 42. The thermoelectric cooler 42 is controlled through a circuit, and has a cold side 421 in contact with the liquid-receiving part 412, and a hot side 422 opposite to the cold side 421. The cold side 421 has a cooling function so as to keep the liquid-receiving part 412 at a constant temperature.

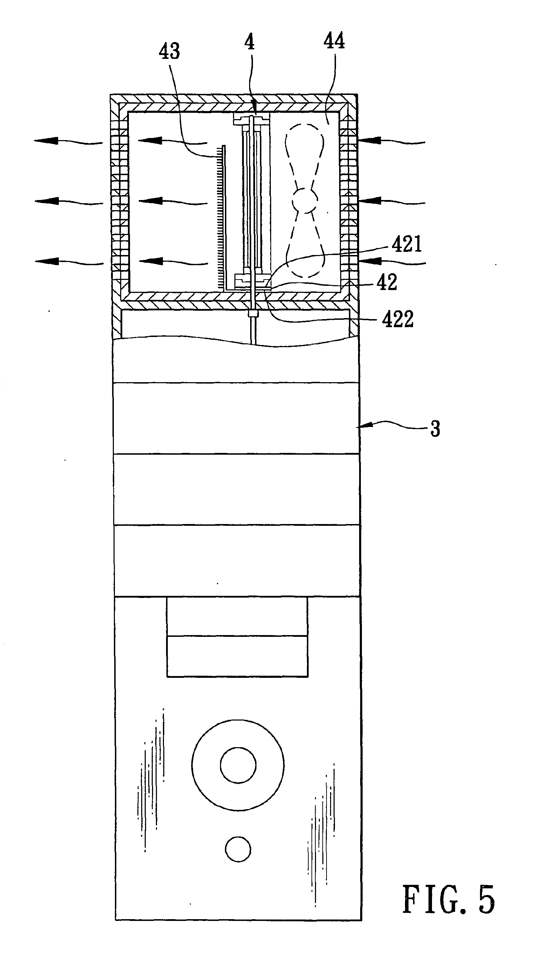

The heat dissipating system of the present invention further comprises a heat sink 43 and a fan 44. The heat sink 43 is disposed adjacent to the condenser 4, and has an L-shaped configuration. The heat sink 43 includes a horizontal plate 431 having a contact portion 4311 in contact with the hot side 422 of the thermoelectric cooler 42, a vertical plate 432 extending upwardly from an end periphery of the horizontal plate 431 and parallel to the condenser 4, and a plurality of fins 433 provided on the vertical plate 432. The fan 44 is disposed proximate to the condenser 4 and the heat sink 43, and directs a current of cold air toward the condenser 4 and the heat sink 43, as best shown in Figure 5.

The heat-absorbing unit 5, in this embodiment, includes first, second, and third cavity bodies 51, 52, 53 respectively in contact with the chips 35 of the computer module 3. Each of the first to third cavity bodies 51, 52, 53 has an inlet 511, 521, 531, and an outlet 512, 522, 532. The inlet 414 and the outlet 415 of the condenser 4 are disposed at a level higher than those of the first to third cavity bodies 51, 52, 53.

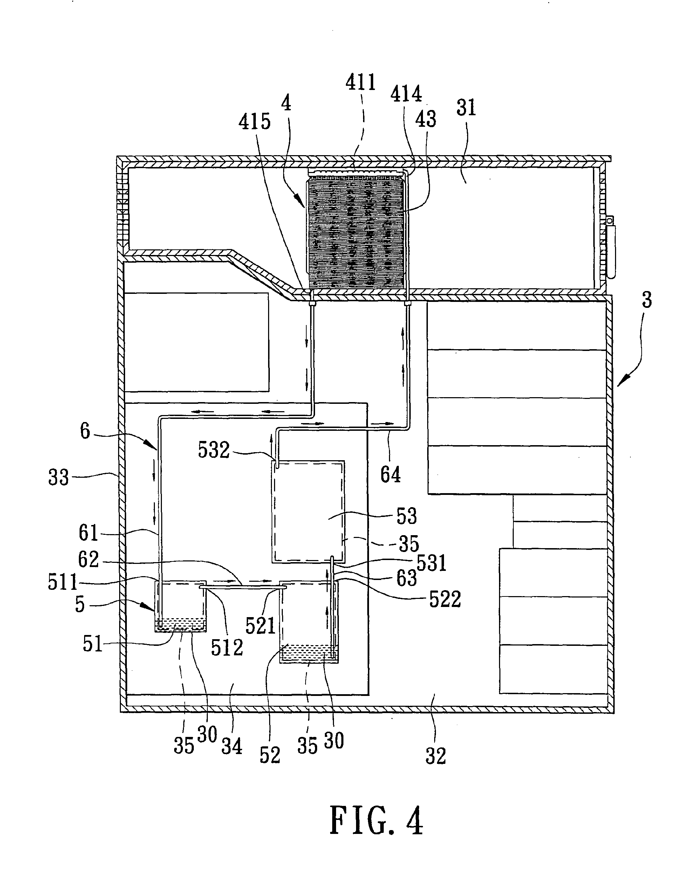

The tubing unit 6, in this embodiment, includes first, second, third, and fourth tubes 61, 62, 63, 64. The first tube 61 is connected to the outlet 415 of the condenser 4 and to the inlet 511 of the first cavity body 51. The second tube 62 is connected to the outlet 512 of the first cavity body 51 and to the inlet 521 of the second cavity body 52. The third tube 63 is connected to the outlet 522 of the second cavity body 52 and to the inlet 531 of the third cavity body 53. The fourth tube 64 is connected to the outlet 532 of the third cavity body 53 and to the inlet 414 of the condenser 4. As such, the first to fourth tubes 61, 62, 63, 64, the condenser 4, and the first to third cavity bodies 51, 52, 53 form a closed circulating loop, as best shown in Figure 4.

A working fluid 30 is injected into the system of the present invention after the first to fourth tubes 61, 62, 63, 64, the first to third cavity bodies 51, 52, 53, and the condenser 4 are evacuated, so that the working fluid 30 circulates in a vacuum environment. In this embodiment, the working fluid 30 is a coolant that is in a liquid state at room temperature. Alternatively, the working fluid 30 may be a super-thermal-conductive liquid.

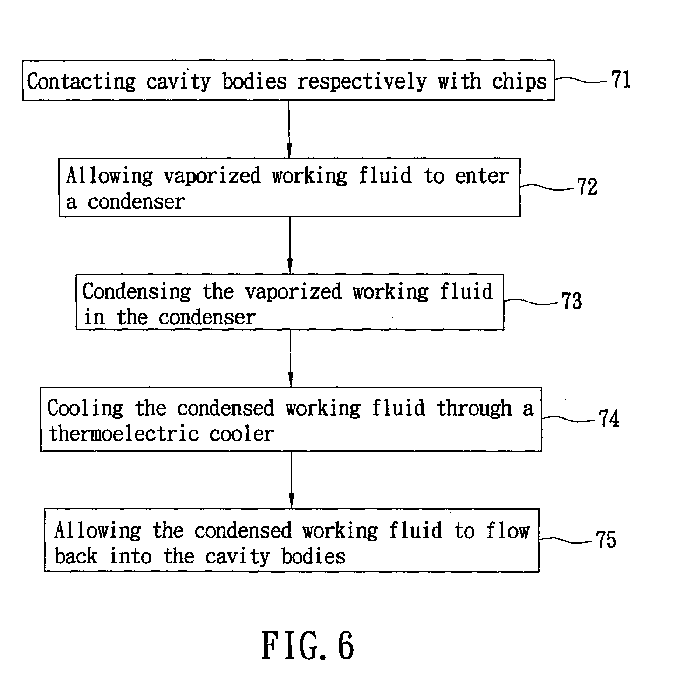

Referring to Figure 6, the steps involved in the method for dissipating heat from the chips 35 are shown.

In step 71, the first, second, and third cavity bodies 51, 52, 53 are placed in contact with the respective chips 35, which have the lowest, medium, and highest temperatures, respectively. Initially, the working fluid 30 is in a liquid state and is in the first and second cavity bodies 51, 52. After the computer module 3 is switched on, the liquid-state working fluid 30 in the first and second cavity bodies 51, 52 is vaporized. As the pressure inside the first cavity body 51 increases, the working fluid 30 in a vaporized state flows into the second cavity body 52 through the second tube 62. As the pressure inside the second cavity body 52 also increases, the liquid-state working fluid 30 in the second cavity body 52 is pressurized and is caused to flow through the third tube 63 and into the third cavity body 53 where the temperature is the highest. The liquid-state working fluid 30 is vaporized in the third cavity body 53.

The number of tubes of the tubing unit 6 can be set according to the number of the module chips 35. As such, the working fluid 30 can flow successively from the lowest- to the highest-temperature module chips 35 through the cavity bodies 51, 52, 53.

In step 72, the vaporized working fluid 30 flows upward by natural convection through the fourth tube 64 from a high-density region, which is the third cavity body 53, into a low-density region, which is the vapor-receiving part 411 of the condenser 4.

In step 73, the fan 44 blows cold air toward the condenser 4 and the heat sink 43 so that the condenser 4 and the heat sink 43 exchange heat with the cold air. The vaporized working fluid 30 from the fourth tube 64 is condensed in the condenser 4, and flows downward through the channels 413 by gravity into the liquid-receiving part 412.

In step 74, through the cooling function of the cold side 421 of the thermoelectric cooler 42, the temperature of the working fluid 30 in a condensed state and in the liquid-receiving part 412 continues to drop to a preset value, and the hot side 422 of the thermoelectric cooler 42 transfers the heat from the condensed working fluid 30 to the heat sink 43, which dissipates the heat.

In step 75, the cooled condensed working fluid 30 in the liquid-receiving part 412 then flows back into the first cavity body 51 through the first tube 61 by gravity so as to repeat the aforementioned steps.

Hence, by circulating the working fluid 30 through the condenser 4, the first to third cavity bodies 51, 52, 53, and the first to fourth tubes 61~64, heat is effectively dissipated.

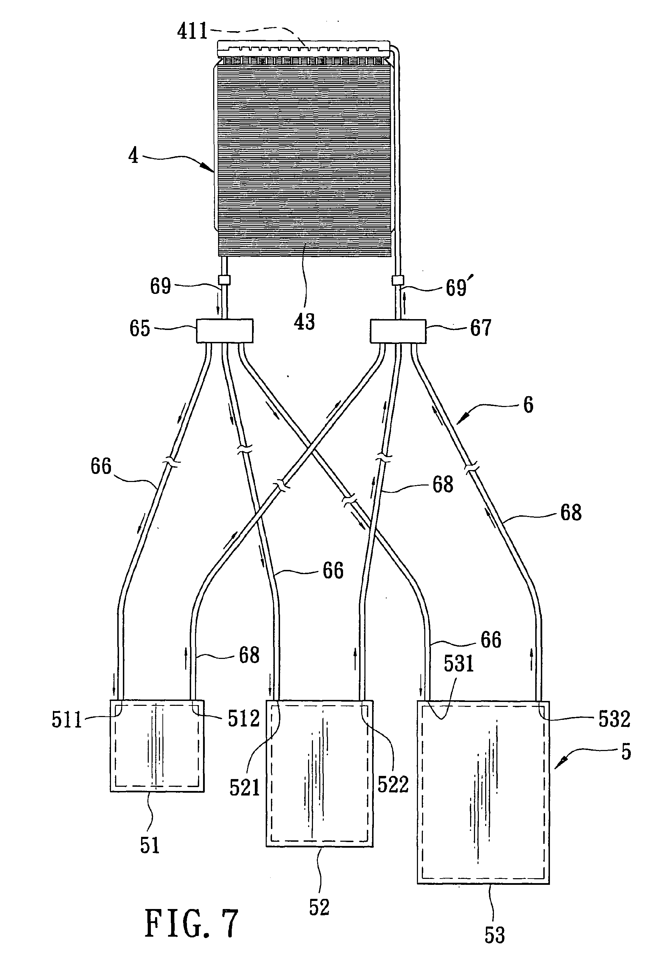

Referring to Figure 7, the heat dissipating system and method according to the second preferred embodiment of the present invention is shown to be similar to the first preferred embodiment. However, in this embodiment, the tubing unit 6 includes spaced-apart first and second manifolds 65, 67, three spaced-apart first tubes 66 each connected between the first manifold 65 and the inlet 511, 521, 531 of the respective cavity body 51, 52, 53 so as to direct the liquid-state working fluid 30 into the respective cavity body 51, 52, 53, three spaced-apart second tubes 68 each connected between the second manifold 67 and the outlet 512, 522, 532 of the respective cavity body 51, 52, 53 so as to direct the vaporized working fluid 30 into the second manifold 67, a third tube 69 connected between the first manifold 65 and the liquid-receiving part 412 (see Figure 2) of the condenser 4, and a fourth tube (69') connected between the second manifold 67 and the vapor-receiving part 411 of the condenser 4.

The condensed working fluid 30 in the liquid-receiving part 412 of the condenser 4 flows down first into the first manifold 65 by gravity, and enters simultaneously the first to third cavity bodies 51, 52, 53 through the first tubes 66. The vaporized working fluid 30 in the first to third cavity bodies 51, 52, 53 is collected at the second manifold 67, and from the second manifold 67, the vaporized working fluid 30 flows through the fourth tube 69' and into the vapor-receiving part 411 of the condenser 4. The working fluid 30 can self-circulate through the condenser 4, the first to third cavity bodies 51, 52, 53, and the first to fourth tubes 66, 68, 69, 69' , thereby effectively dissipating the heat in the system.

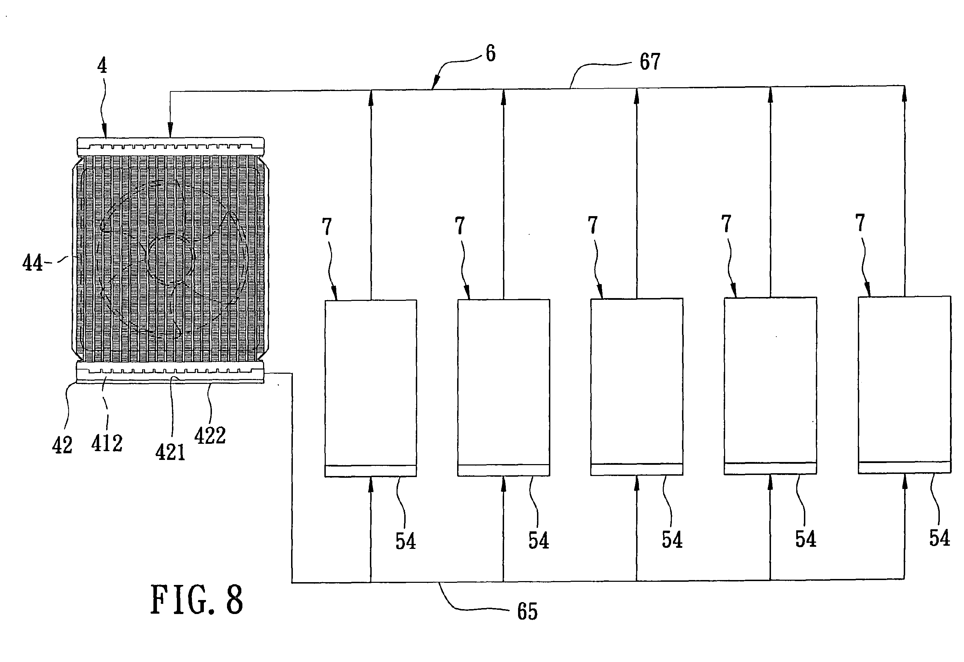

Referring to Figure 8, the heat dissipating system and method according to the third preferred embodiment of the present invention is shown to be similar to the second preferred embodiment. However, in this embodiment, the heat-absorbing unit 5 includes five cavity bodies 54 connected in parallel to each other using the first and second manifolds 65, 67 of the tubing unit 6. Each cavity body 54 is in contact with an electronic component 7 that can generate heat. The arrangement of the tubing unit 6 is as illustrated in Figure 8.

The heat dissipating system and method of the present invention may also be applicable to dissipating heat of an engine or a machine of a car, or any other article that needs heat dissipation.

From the aforementioned description, the advantages of the heat dissipating system and method of the present invention may be summarized as follows:
1. Through phase change of the working fluid 30 from liquid to vapor and vapor to liquid, the working fluid 30 can undergo a self-circulating effect. Hence, compared to the conventional heat dissipating system that utilizes the pressure-increasing pump 13 (see Figure 1), the system of the present invention not only utilizes simple components, and reduces cost and noise to a minimum, but also minimizes self-generated heat.
2. The working fluid 30 of the present invention, while in a liquid state, can effectively absorb heat from the module chips 35 through heat conduction, and is then vaporized so as to exchange heat with the condenser 4. As such, not only can a heat dissipating effect and efficiency be enhanced, the present invention can also cooperate with the thermoelectric cooler 42 to control the temperature through an electric-controlled process, so that the condensed working fluid 30 can be maintained in a particular temperature range for any length of time, thereby ensuring a favorable heat dissipation effect.
3. The working fluid 30 of the present invention makes use of a coolant or a super-thermal-conductive liquid, so that no freezing of the working fluid 30 is likely to occur when the working fluid 30 is used at a temperature below 0°C . Hence, the heat dissipation process can be carried out smoothly. Further, even if there is a leak in the system, the working fluid 30 will turn immediately into vapor so as not to damage electronic circuitry and/or elements of the heat dissipating system.

## Claims

1. A heat dissipating system, **characterized by**:
a heat-absorbing unit (5) having at least one cavity body (51, 52, 53, 54) adapted to contact a heat source (35, 7), and a working fluid (30) received in said cavity body (51, 52,53, 54);
a condenser (4) to condense said working fluid (30); and
a tubing unit (6) connected fluidly to said condenser (4) and said heat-absorbing unit (5), said working fluid (30) flowing through said tubing unit (6) to circulate from said condenser (4) to said heat-absorbing unit (5) by gravity and from said heat-absorbing unit (5) to said condenser (4) by natural convection, said tubing unit (6) forming a closed circulating loop with said heat-absorbing unit (5) and said condenser (4).

2. The heat dissipating system of Claim 1, **characterized in that** said condenser (4) has a top end provided with a vapor-receiving part (411), an inlet (414) connected fluidly to said vapor-receiving part (411), a bottom end provided with a liquid-receiving part (412), an outlet (415) connected fluidly to said liquid-receiving part (412), and a plurality of channels (413) connected between said vapor-receiving and liquid-receiving parts (411, 412), said inlet (414) and said outlet (415) of said condenser (4) being disposed at a level higher than thatofsaidcavitybody (51, 52, 53, 54), said working fluid (30) flowing from said cavity body (51, 52,53, 54) to said inlet (414) of said condenser (4) when vaporized and from said outlet (415) of said condenser (4) to said cavity body (51, 52, 53, 54) after being condensed.

3. The heat dissipating system of Claim 2, **characterized in that** said condenser (4) includes a thermoelectric cooler (42) having a cold side (421) in contact with said liquid-receiving part (412), and a hot side (422) opposite to said cold side (421).

4. The heat dissipating system of Claim 3, further **characterized by** a heat sink (43) disposed adjacent to said condenser (4) and having a contact portion (4311) in contact with said hot side (422), and a plurality of fins (433).

5. The heat dissipating system of Claim 4, further **characterized by** a fan (44) disposed proximate to said condenser (4) and said heat sink (43).

6. The heat dissipating system of Claim 2, **characterized in that** said heat-absorbing unit (5) includes a plurality of said cavity bodies (51, 52, 53, 54), each of said cavity bodies (51, 52, 53, 54) having an inlet (511, 521, 531) and an outlet (512, 522, 532).

7. The heat dissipating system of Claim 6, **characterized in that** said tubing unit (6) includes a plurality of tubes (61, 62, 63, 64), said cavity bodies (51, 52, 53) and said condenser (4) being interconnected in series through said tubes (61, 62, 63, 64), each of said tubes (61, 62, 63, 64) being connected to said inlet (511, 521, 531, 414) of one of said cavity bodies (51, 52, 53) and said condenser (4) and to said outlet (512, 522, 532, 415) of the other one of said cavity bodies (51, 52, 53) and said condenser (4).

8. The heat dissipating system of Claim 6, **characterized in that** said tubing unit (6) includes a first manifold (65), a plurality of spaced-apart first tubes (66) each connected between said first manifold (65) and said inlet (511, 521, 531) of a respective one of said cavity bodies (51, 52, 53), a second manifold (67), a plurality of spaced-apart second tubes (68) each connected between said second manifold (67) and said outlet (512, 522, 532) of the respective one of said cavity bodies (51, 52, 53), a third tube (69) connected between said liquid-receiving part (412) and said first manifold (65), and a fourth tube (69') connected between said vapor-receiving part (411) and said second manifold (67).

9. A computer module (3) **characterized by**:
a housing (33);
at least one chip (35, 7) disposed in said housing (33);
a heat-absorbing unit (5) having at least one cavity body (51, 52, 53, 54) contacting said chip (35, 7), and a working fluid (30) received in said cavity body (51, 52, 53, 54);
a condenser (4) disposed in said housing (33) to condense said working fluid (30); and
a tubing unit (6) connected fluidly to said condenser (4) and said heat-absorbing unit (5), said working fluid (30) flowing through said tubing unit (6) to circulate from said condenser (4) to said heat-absorbing unit (5) by gravity and from said heat-absorbing unit (5) to said condenser (4) by natural convection, said tubing unit (6) forming a closed circulating loop with said heat-absorbing unit (5) and said condenser (4).

10. The computer module of Claim 9, **characterized in that** said condenser (4) has a top end provided with a vapor-receiving part (411), an inlet (414) connected fluidly to said vapor-receiving part (411), a bottom end provided with a liquid-receiving part (412), an outlet (415) connected fluidly to said liquid-receiving part (412), and a plurality of channels (413) connected between said vapor-receiving and liquid-receiving parts (411, 412), said inlet (414) and said outlet (415) of said condenser (4) being disposed at a level higher than that of said cavity body (51, 52, 53, 54), said working fluid (30) flowing from said cavity body (51, 52, 53, 54) to said inlet (414) of said condenser (4) when vaporized and from said outlet (415) of said condenser (4) to said cavity body (51, 52, 53, 54) after being condensed.

11. The computer module of Claim 10, **characterized in that** said condenser (4) includes a thermoelectric cooler (42) having a cold side (421) in contact with saidliquid-receivingpart (412), andahot side (422) opposite to said cold side (421).

12. The computer module of Claim 11, further **characterized by** a heat sink (43) disposed adjacent to said condenser (4) and having a contact portion (4311) in contact with said hot side (422), and a plurality of fins (433).

13. The computer module of Claim 12, further **characterized by** a fan (44) disposed proximate to said condenser (4) and said heat sink (43).

14. A method for dissipating heat from a heat source (35, 7), **characterized by**:
(a) contacting the heat source (35, 7) with a heat-absorbing cavity body (51, 52, 53, 54) to cause a working fluid (30) contained in the cavity body (51, 52, 53, 54) to vaporize;
(b) allowing the vaporized working fluid (30) to flow upward and enter a condenser (4) by natural convection;
(c) condensing the vaporized working fluid (30) in the condenser (4);
(d) cooling the condensed working fluid (30) using a thermoelectric cooler (42) and a heat sink (43); and
(e) allowing the condensed working fluid (30) to flow downward and back into the cavity body (51, 52, 53, 54) by gravity.
